Europäisches Patentamt

European Patent Office — (11) Publication number: **0 001 722**
Office européen des brevets — A2

(19)

(12) **EUROPEAN PATENT APPLICATION**

(21) Application number: **78300545.7**

(22) Date of filing: **25.10.78**

(51) Int. Cl.²: **H 03 K 17/10**
H 02 H 3/08, H 02 H 9/04
G 05 F 1/52, G 05 F 1/62
H 03 K 17/08

(30) Priority: **25.10.77 GB 44397/77**

(43) Date of publication of application:
**02.05.79 Bulletin 79/9**

(84) Designated contracting states:
**CH DE FR GB SE**

(71) Applicant: **EUROPEAN ATOMIC ENERGY COMMUNITY (EURATOM)**
**Batiment Jean Monnet Plateau du Kirchberg Bôite Postale 1907**
**Luxembourg(LU)**

(72) Inventor: **Mondino, Dr Pier Luigi**
**Cosener's House Abbey Close**
**Abingdon(GB)**

(74) Representative: **Horton, Andrew Robert Grant et al,**
**BOULT, WADE & TENNANT 34 Cursitor Street**
**London, EC4A 1PQ(GB)**

(54) Fast high voltage on-off switch with possibility of voltage regulation, load- and self- protection.

(57) A power supply comprises at least two supply circuits the output terminals of which are connected in series to supply a voltage across a load ($V_L$). Each circuit comprises a D.C. voltage source ($V_m$) in series with a switching valve (S), the maximum voltage across which is limited by diodes ($D_1$) connected across the output terminals of the respective supply terminals, and a protection circuit (4). The protection circuit responds to the current flowing through the load, and on the occurrence of a first current threshold switches off the valve (S), and in the event of a higher current threshold fires a crowbar link (I) which shunts the source ($V_m$).

FIG. 2.

1.

"FAST HIGH VOLTAGE ON-OFF SWITCH WITH POSSIBILITY OF
VOLTAGE REGULATION, LOAD- AND SELF- PROTECTION"

This invention relates to a power supply which is capable of providing an electrical output voltage of at least 100 kilovolts across a load.

At present valves are commercially available which operate at up to 100kV and are capable of switching with an opening time of less than $10\,\mu s$, and tetrodes which operate at up to 200 kV and 65A with similar switching capabilities are in the developmental stage. It is technologically difficult to provide switching of higher voltages than a single valve can provide by matching valves in series, for example because inequality of internal resistance or interelectrode capacitance leads to uneven voltage sharing and reduced lifetime of a consequentially overloaded valve.

A power supply capable of delivering voltages higher than the maximum rated voltages of the switching valves in accordance with the present invention comprises at least two supply circuits of which the output terminals are connected in series, of which circuits each comprises a source of d.c. voltage, an electronic amplifying valve disposed in series with the respective source, a clipping diode across the respective output terminals, and a protective circuit which is disposed to respond to the current supplied by the respective supply circuit and, on the occurrence of progressively higher currents to switch off the respective valve and to fire a crowbar circuit which shunts the respective source.

Preferred embodiments of the invention are now described, illustrated by way of example with reference to the accompanying drawings, in which:-

Figure 1 is a schematic diagram of an embodiment of the invention with two voltage sources;

Figure 2 is a schematic diagram of an embodiment of the invention with three voltage sources; and

Figure 3 is an exemplary detailed circuit diagram of a protection circuit which may be employed in Figures 1 or 2.

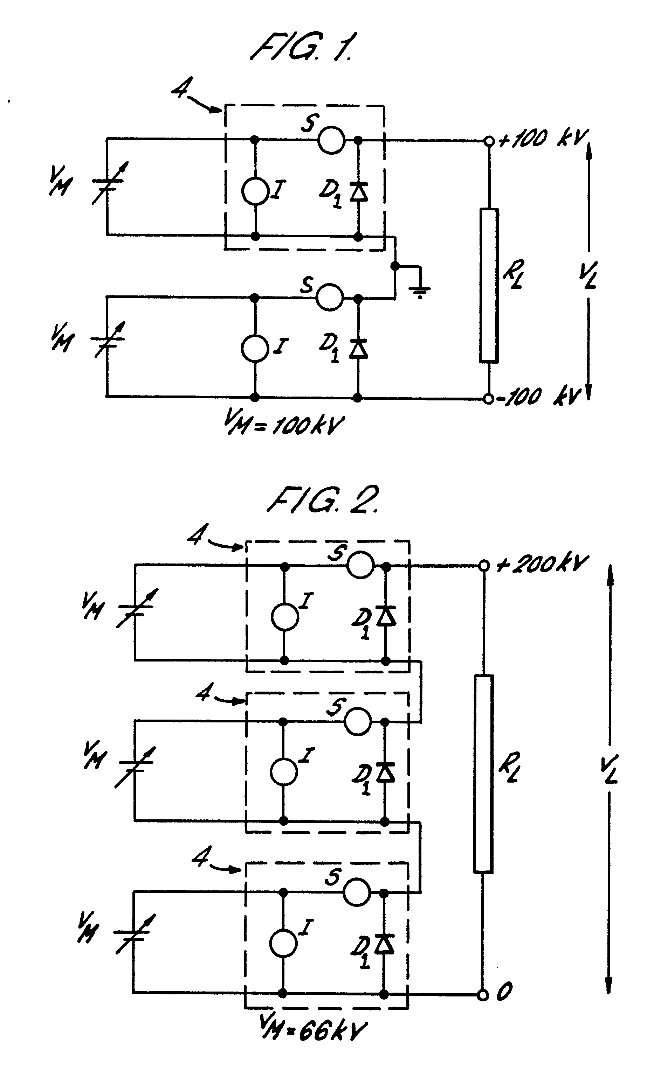

In Figures 1 and 2 variable voltage sources $V_m$ are connected in series to supply voltage $V_L$ across a load $R_L$. Each source $V_m$ has an associated protection circuit 4 which includes a crowbar shorting link I, a switching valve S, and clipping diodes D, which limit the maximum voltage across each valve S. The circuit shown in Figure 1 is balanced, the load terminals being at maxima of + 100kV and - 100kV respectively; the circuit shown in Figure 2 is unbalanced, the load terminals being at 0kV and 200kV (maximum) respectively.

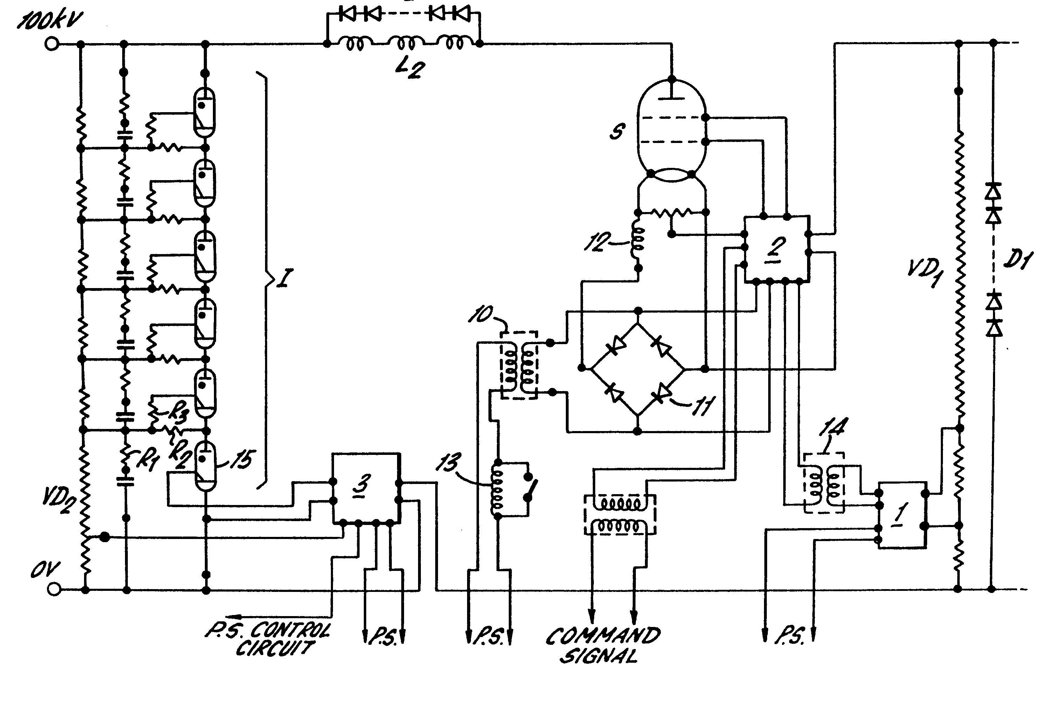

Figure 3 shows a protection circuit designed for a maximum source voltage $V_m$ of 100kV and a maximum load current of 25A. The switching valve S is a tetrode, such as type No. CQS-200-3 made by Brown Boveri which in addition to providing a switching function also assists in controlling the load voltage. Current is applied to the filament _via_ a transformer 10 which is insulated for 100kV DC, single phase rectifier 11, and smoothing inductor 12 which minimises voltage fluctuations between the cathode and the control grid. When the filament is first switched on the surge current is limited by an inductor 13, which also reduces the filament current to 60% of the rated value during "OFF" periods. Shortly before the beginning of an "ON" phase inductor 13 is short circuited.

The tetrode S is switched on during approximately $20\mu$s in a preset procedure by which the tube is left with a voltage drop which is reduced to the selected operating value when a voltage regulator circuit comes into operation about 1 ms after switch-on. In the voltage regulator circuit, device 1 compares a signal from a voltage divider $VD_1$ with a reference value. The resulting signal is converted into AC at $10^4$Hz, transferred to the high voltage side through an insulation transformer 14, rectified and applied to the tetrode control grid. The bandwidth of the regulator circuit is limited by the DC-AC-DC conversion. If a short circuit occurs in the load, a rise in the load current to a threshold of 30A is detected by device 2 which switches off the tetrode in less than $10\mu$s.

The crowbar I consists of a series connection of six ignitrons of the type BX476 made by English Electric. When the first ignitron 14 is switched "ON" a current from the parallel capacitor flows through resistors $R_1$ and $R_2$ applying a voltage in the range of 1.5 - 4kV to the control grid of the next ignitron, which is then also triggered. On successive firing of the ignitrons in the crowbar the voltage across the chain decreases in steps because of the high equivalent inductance of the power supply. The complete ignitron chain may be fired in less than 10 μs.

The crowbar link is triggered in the event of a simultaneous short circuit in the load and breakdown of the tetrode, or when an abnormally high voltage appears across the output of the source $V_m$. The successive trigger mechanism has been found more reliable than other circuits designed to give simultaneous firing of the ignitrons.

The rise time of the current in the event of a short circuit in the load is limited by inductor $L_2$, the value of which (50 mH, 100 kV, 50 A peak current) is chosen so that if simultaneous breakdown in the load and tetrode occurs there is a time lag of 10 μs between the threshold current level of 30A and a second threshold of 50A. Device 3 senses the 50A threshold and puts the power supply converters into inverter operation and triggers the first ignitron 14 in the crowbar I.

Diode $D_2$ connected in parallel with inductor $L_2$ avoids overvoltage during load current switch-off. Diodes $D_1$ and $D_2$ both consist of a string of diodes (120 diodes of S12/AR15 type) insulated in oil.

Each protection circuit 4 operates similarly. In addition to triggering by short circuit currents as described, a voltage divider $VD_2$ detects a predetermined voltage threshold which fires the crowbar I to protect the tetrode S in the event of faults in voltage source $V_m$.

A particular application of a power supply similar to that described is in the control circuit of a neutral beam injector. Neutral beam injection is a technique which is employed in boosting the temperature of plasmas within the magnetic confinement of fusion reactors. The injector produces a beam of high velocity neutral atomic particles which, because they are uncharged, can cross the magnetic field and enter the plasma. Once in the plasma the beam is thermally ionized and the ionized particles, confined by the magnetic field, relinquish their kinetic energy via collision processes to heat the plasma. An injector is typically operated for a pulse of about 12 seconds, during which short circuiting of the high voltages applied to the accelerating grids frequently occurs, particularly in the initial conditioning phase. In order to avoid damaging the injector it is necessary that short circuit currents are rapidly reduced, for example within $10\,\mu s$, which is provided by the power supply and protection circuit of the invention. After a delay period, typically 1 ms, the voltage is reapplied over the load (the injector) by switching the tetrode on, with the required operating voltage being reached in $20\text{-}50\,\mu s$. If a further short circuit occurs the switching of the protection circuits is repeated. It may be necessary, in this particular application, for several switching cycles to be performed in rapid succession.

CLAIMS

1.    A power supply which is capable of providing an electrical output voltage of at least 100 kilovolts, across a load, comprising at least two supply circuits of which the output terminals are connected in series, of which circuits each comprises a source of d.c. voltage, an electronic amplifying valve disposed in series with the respective source, a clipping diode across the respective output terminals, and a protective circuit which is disposed to respond to the current supplied by the respective supply circuit and, on the occurrence of progressively higher currents to switch off the respective valve and to fire a crowbar circuit which shunts the respective source.

2.    A power supply according to claim 1 in which each valve constitutes part of a respective regulator of the supply circuit's output voltage, and each regulator comprises a control circuit which senses a fraction of the voltage across the respective output terminals.

3.    A power supply according to claim 1 or claim 2 in which the total inverse voltage of the respective clipping diodes is equal to the respective DC source voltage.

4.    A power supply according to any preceding claim in which the crowbar comprises a chain of ignitrons connected so that they are consecutively triggered.

5.    A power supply according to any preceding claim in which the valve is a tetrode.

6.    A power supply according to any preceding claim in which the crowbar is fired when the source output voltage exceeds a predetermined value.

# FIG. 1.

$V_M = 100 kV$

# FIG. 2.

$V_M = 66 kV$

FIG. 3.

0001722